# EUROPEAN PATENT APPLICATION

(11) **EP 3 862 166 A1**
(43) Date of publication of application: **11.08.2021**
(21) Application number: 18936214.8
(22) Date of filing: 02.10.2018
(51) Int. Cl.: B29C 59/02

(54) **LIQUID-REPELLENT PLASTIC MOLDED BODY AND PRODUCTION METHOD THEREFOR**

(71) Applicant: Toyo Seikan Group Holdings, Ltd., Shinagawa-ku Tokyo 141-8627 (JP)
(72) Inventor: IWASAKI, Tsutomu, Yokohama-shi, Kanagawa 240-0062 (JP); AOYA, Masaki, Yokohama-shi, Kanagawa 240-0062 (JP); OONUKI, Ryuuji, Yokohama-shi, Kanagawa 240-0062 (JP); KUNINORI, Masahiro, Yokohama-shi, Kanagawa 240-0062 (JP)
(74) Representative: J A Kemp LLP
(86) International application number: PCT/JP2018/036869
(87) International publication number: WO 2020/070800

(57) **Abstract**

A liquid-repellent plastic molded body 1 according to the present invention has a liquid-repellent surface. The liquid-repellent surface has a re-entrant structure surface formed by an array of pillars 20 each having a head portion 20a with an enlarged diameter. At least a part of the re-entrant structure surface has a fluorine-containing surface in which fluorine atoms are distributed.

## Description

### Technical Field:

The present invention relates to a plastic molded body having a surface excellent in liquid repellency and a method for producing the same.

### Background Art:

Plastics, which are usually easier to mold than glass, metals and the like, can be molded easily into various shapes, and thus they are used in various applications. Among them, the field of packaging containers such as a pouched container and a bottle is a typical field of plastics applications.

Meanwhile, in a case where a container as mentioned above contains a viscous fluid, it is required to have dischargeability. More specifically, the container to contain a viscous fluid needs to allow the contents to be discharged rapidly and completely with nothing adhering and remaining inside the container.

In order to enhance dischargeability with respect to a viscous fluid, a plastic surface forming an inner surface of the container is imparted with higher liquid repellency to the contents so as to improve lubricity to the contents.

For this purpose, it is known to form ruggedness on the surface.

Forming ruggedness on the surface is a way to physically impart liquid repellency by means of the surface shape. More specifically, when a liquid flows on the rugged surface, air pockets are formed in recessed portions, allowing solid-liquid contact and gas-liquid contact to be made between the rugged surface and the liquid. Since gas (air) is the most hydrophobic substance, remarkably high liquid repellency is achieved by appropriately setting the density of the ruggedness. With this technique, however, as the liquid flows repeatedly on the rugged surface, the liquid gradually accumulates in the recessed portions, so that the air pockets are gradually lost. As a result, liquid repellency is gradually decreased.

The applicant of the present application proposes in Patent document 1 a plastic molded body that suppresses time degradation of liquid repellency when achieving liquid repellency by means of a rugged surface. In this document, the plastic molded body has a fractal hierarchical rugged surface structure in which primary ruggedness is formed on the surface, and fine secondary ruggedness is formed in at least a part of the primary ruggedness.

In this molded body, since the additional fine secondary ruggedness is formed in a region of the primary ruggedness, the entrance of liquid into the primary ruggedness is effectively suppressed, and thus liquid repellency by means of the primary ruggedness is stably maintained.

However, even with this technique, there is a limit in suppressing a decrease in liquid draining property and liquid falling property. In other words, it is impossible to completely prevent the entrance of liquid into the secondary ruggedness, and there is a gradual decrease in liquid repellency by means of the air pockets formed in the secondary ruggedness, which gradually causes the liquid to enter the primary ruggedness. As a result, time degradation of liquid repellency is inevitable.

The present applicant also proposes in Patent document 2 a technique in which, in a molded body with a fractal rugged surface structure (rough surface) as described above, the rough surface is subjected to a fluorine plasma treatment, thereby incorporating fluorine atoms into a resin forming the surface.

This technique is a way to chemically improve liquid repellency of the rugged surface by distributing fluorine atoms on the surface. This considerably improves a decrease in liquid repellency after a liquid flows repeatedly on the rugged surface. Moreover, since fluorine atoms are distributed on the surface by a fluorine plasma treatment, there is no possibility that a film of the fluorine atoms peels off from the surface to cause a decrease in liquid repellency of the surface.

However, although this technique is favorable, for example, to impart liquid repellency to an opening of a container to prevent liquid dripping, sufficient liquid repellency may not be obtained when a viscous fluid is in constant contact with the liquid-repellent surface. Thus, further improvement is required.

Further, Patent document 3, which discloses a nozzle plate for an ink jet head having a re-entrant structure, describes that the nozzle plate having this structure exhibits excellent liquid repellency and effectively prevents ink contamination of the nozzle head.

However, this re-entrant structure is produced through an extremely complicated process as follows: forming a mask material on a predetermined surface portion of the nozzle plate by photolithography; forming, by etching with a dry etching device, recessed portions that form the re-entrant structure; and removing the mask material. Though this technique is applicable to a nozzle plate for an ink jet head made of silicone or the like, it is totally inapplicable to the field of packaging materials in terms of cost, productivity and the like. Moreover, Patent document 3 gives no consideration to, for example, the life of liquid repellency in a state where a viscous liquid is in constant contact.

### Prior Art Documents:

### Patent Documents:

Patent Document 1: JP-A-2015-80929
Patent Document 2: JP-A-2016-88947
Patent Document 3: JP-A-2013-52546

### Summary of the Invention:

### Problems to be solved by the invention:

Therefore, an object of the present invention is to provide a liquid-repellent plastic molded body that maintains excellent liquid repellency for a long period even in a case where a liquid, especially a viscous fluid, is kept in constant contact, and that can be produced by a method applicable also to the field of packaging materials, and a method for producing the same.

### Means for solving the problems:

The present invention provides a liquid-repellent plastic molded body having a liquid-repellent surface. The liquid-repellent surface has a re-entrant structure surface formed by an array of pillars each having a head portion with an enlarged diameter, and at least a part of the re-entrant structure surface has a fluorine-containing surface in which fluorine atoms are distributed.

According to the liquid-repellent plastic molded body of the present invention, it is preferable that:
(1) the fluorine-containing surfaces is a fluorine plasma-treated surface; and
(2) the liquid-repellent plastic molded body has a film form.

In particular, the liquid-repellent plastic molded body in a film form is formed into a pouched container.

Further, the present invention provides a method (a transfer method 1 or a reflow method) for producing a liquid-repellent plastic molded body. The method includes the steps of:
preparing a plastic molded body molded into a predetermined shape and a transfer mold having, as a transfer surface, a rugged surface formed by an array of straight body-shaped protruded columnar portions;
transferring the rugged transfer surface of the transfer mold, which is made to face a surface of the plastic molded body, to the surface of the plastic molded body so as to form a precursor of a re-entrant structure surface;
deforming the precursor into a re-entrant structure surface by heating and/or pressurizing pillars distributed on the precursor formed by transfer so as to enlarge a diameter of a top portion of each of the pillars; and
distributing fluorine atoms to at least a part of the re-entrant structure surface.

The present invention also provides a method (a transfer method 2) for producing a liquid-repellent plastic molded body. The method includes the steps of:
preparing a plastic molded body molded into a predetermined shape and a transfer mold having a rugged transfer surface for forming a rugged re-entrant structure surface by transfer;
transferring the rugged transfer surface of the transfer mold, which is made to face a surface of the plastic molded body, to the surface of the plastic molded body so as to form a re-entrant structure surface on the surface of the plastic molded body; and
distributing fluorine atoms to at least a part of the re-entrant structure surface.

According to the above-described two methods, which are referred to as a transfer method, it is preferable that:
(1) in the step of distributing fluorine atoms, the surface of the plastic molded body is formed of a resin that contains a fluorine-containing compound, and when the fluorine-containing compound bleeds out, the fluorine atoms are distributed on the surface; or
(2) in the step of distributing fluorine atoms, at least a part of the re-entrant structure surface is subjected to a fluorine plasma treatment, so that the fluorine atoms are distributed on the surface.

Furthermore, the present invention provides a method for producing a liquid-repellent plastic molded body. The method includes the steps of:
preparing a plastic molded body molded into a predetermined shape and a plastic columnar body having an end surface with an enlarged diameter;
forming a re-entrant structure surface by joining a plurality of the plastic columnar bodies to a surface of the plastic molded body; and
distributing fluorine atoms to at least a part of the re-entrant structure surface.

This method is referred to as a joining method, in which the columnar bodies of a predetermined shape are joined to the surface of the plastic molded body, thereby forming the re-entrant structure. According to the joining method,
(1) in the step of forming a re-entrant structure surface, the plastic columnar bodies are joined to the surface of the plastic molded body by electrostatic flocking (which is referred to as an electrostatic flocking method), or
(2) in the step of forming a re-entrant structure surface, the plastic columnar bodies are joined to the surface of the plastic molded body by thermally spraying the plastic columnar bodies on the surface of the plastic molded body (which is referred to as a thermal spraying method).

According to the electrostatic flocking method or the thermal spraying method, it is preferable that:
(a) in the step of distributing fluorine atoms, at least a part of the re-entrant structure surface is formed of a resin that contains a fluorine-containing compound, and when the fluorine-containing compound bleeds out, the fluorine atoms are distributed on the surface; or
(b) in the step of distributing fluorine atoms, at least a part of the re-entrant structure surface is subjected to a fluorine plasma treatment, so that the fluorine atoms are distributed on the surface.

### Effects of the invention:

According to the liquid-repellent plastic molded body of the present invention, the pillars each having a top portion with an enlarged diameter are arrayed on its surface. The array of the pillars forms the re-entrant structure. Namely, each recessed portion formed between the pillars is narrowed at its top. In the present invention, this re-entrant structure makes it difficult for a liquid flowing on its surface to enter the recessed portion, maintaining the so-called stability of the Cassie mode, thereby achieving stable liquid repellency. Especially importantly, since fluorine atoms are distributed on the surface, liquid repellency is maintained stably for a remarkably long period even in a case where the liquid is kept in constant contact.

Further, since this liquid-repellent plastic molded body can be produced continuously without, for example, directly etching the surface of the molded body, there is an advantage in that it is cheap to produce and has high productivity.

Accordingly, the liquid-repellent plastic molded body of the present invention is applied preferably to the field of packaging (especially, containers) in which a liquid is to be kept in constant contact. For example, in a case where the present invention is used as a pouched container to contain a viscous fluid (e.g., having a viscosity of 250 mPa·s or more at 25 °C) such as a curry, the contents can be discharged rapidly with nothing adhering and remaining inside even after a lapse of as long as six months to one year after production.

### Brief Description of the Drawings:

[Fig. 1]: a schematic diagram showing a contact pattern of a liquid droplet on a rough surface in each of the Cassie-Baxter model and the Wenzel model;
[Fig. 2] : a schematic diagram showing a form of a rugged surface of a conventionally known pillar structure;
[Fig. 3]: a diagram showing a form of a rugged surface of a re-entrant structure according to the present invention; [Fig. 4]: a diagram showing a process of producing a liquid-repellent plastic molded body of the present invention by a transfer method 1 (reflow method);
[Fig. 5] : a schematic side cross-sectional view showing a form of a transfer substrate to be used for forming a transfer mold for use in a transfer method 2;
[Fig. 6] : a diagram showing an example of a columnar body for forming a re-entrant structure surface to be used in a joining method;
[Fig. 7] : a diagram showing an example (electrostatic flocking method) of a process of producing a liquid-repellent plastic molded body of the present invention by a joining method; and [Fig. 8] : a diagram showing another example (spraying method) of a process of producing a liquid-repellent plastic molded body of the present invention by a joining method.

### Mode for Carrying Out the Invention:

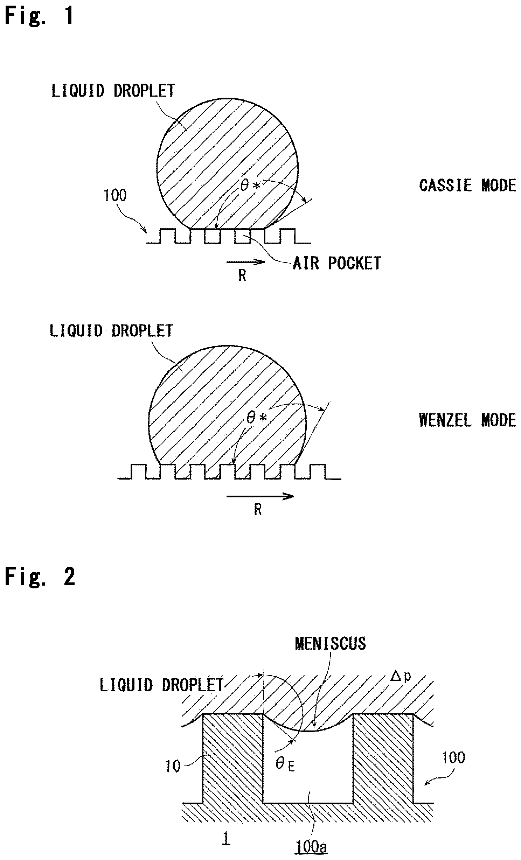

A description will be given of the principle of liquid repellency by means of a rough surface (rugged surface) with reference to Fig. 1. In the Cassie mode in which a liquid droplet is placed on a rough surface 100, recessed portions in the rough surface 100 serve as air pockets, allowing the liquid droplet to be in composite contact with a solid and a gas (air) . It is known that the composite contact achieves high liquid repellency because the liquid droplet has a small radius R on a contact interface, and the liquid is in contact with air as the most hydrophobic substance. Specifically, an apparent contract angle e* is close to 180°.

On the other hand, in a case where the liquid droplet enters the recessed portions in the rough surface 100, which is shown as the Wenzel mode, the liquid droplet is not in composite contact but in contact only with the solid. In the Wenzel mode, the liquid droplet has a large contact radius R on the contact interface, and the apparent contract angle e* is similarly close to 180°. It is known that liquid repellency is exhibited also in this case.

As described above, it is known that liquid repellency is improved in either state of the Wenzel mode and the Cassie mode. However, in order to enhance liquid repellency, it is considered to be necessary that the Cassie mode, instead of the Wenzel mode, be maintained stably (the air pockets in the recessed portions be maintained stably). More specifically, in the Wenzel mode, since the interface between a liquid phase and a solid phase is larger, and thus a stronger adsorption power is applied physically to the interface, the liquid droplet does not fall easily while the contact angle is large enough to show liquid repellency. In the Cassie mode, since the interface is smaller, the liquid droplet only needs to overcome a low energy barrier to fall. Thus, it is considered that the liquid droplet falls easily and repeatedly.

In the present invention, in order to effectively maintain the contact of the liquid droplet in the Cassie mode, a re-entrant structure is formed on the surface 100 of a plastic molded body 1.

The re-entrant structure has a configuration in which the top of the recessed portion in the rugged surface is narrower than the bottom thereof, so that the liquid droplet is prevented from easily entering the recessed portion. As a result, the Cassie mode is maintained stably for a long period.

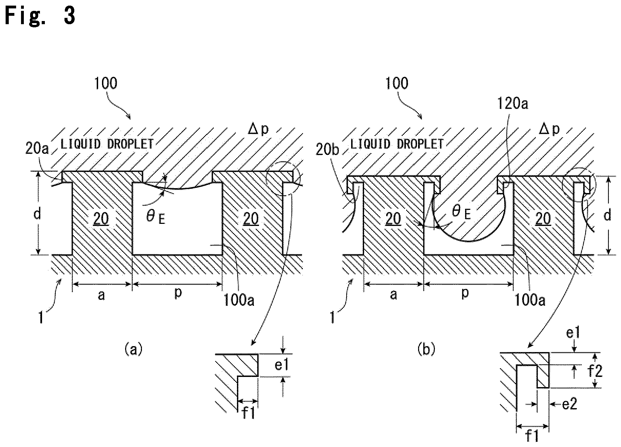

A more specific description will be given with reference to Figs. 2 and 3 each showing a form of the rugged surface. Each of these figures is a schematic diagram showing the rugged surface (rough surface) 100 formed by an array of pillars (columnar bodies) 10 or 20 on a surface of the plastic molded body 1.

In Fig.2, straight body-shaped pillars (hereinafter, referred to as normal pillars) 10 are arrayed. The rugged surface 100 formed from this pattern, which is known conventionally, may be hereinafter referred to as a pillar structure.

On the other hand, Fig. 3(a) and 3(b) shows the rugged surface 100 formed from a pattern of the re-entrant structure adopted in the present invention. According to this pattern, pillars (hereinafter, referred to as pinning pillars) 20 each having a head portion with an enlarged diameter are arrayed. Thus, a recessed portion 100a has a larger bottom and a narrower top. Namely, the re-entrant structure is formed.

Fig. 3(a) shows a typical re-entrant structure (hereinafter, may be referred to as a single re-entrant structure). In the pattern shown in Fig. 3(b), the circumferential rim of a head portion 20a of each of the pinning pillars 20 is folded, so that a void 20b is formed within the head portion 20a. This pattern can be referred to as a double re-entrant structure.

In the pillar structure in Fig. 2, in a state where a liquid droplet is placed on the rugged surface 100, a pressure Δp is applied due to the self-weight of the liquid droplet, disturbance, and the like. In a liquid-repellent state in which the liquid droplet forms a contact angle θE of more than 90° with a material of the rugged surface (in Fig.2, θE = 130°), a downwardly convex meniscus is formed by the surface tension of the liquid droplet (pinning effect), and thus the liquid droplet does not enter the recessed portion 100a. However, in a lyophilic state in which the liquid droplet forms a contact angle θE of 90° or less, an upwardly convex meniscus is formed, and thus the liquid droplet enters the recessed portion 100a.

On the other hand, in the re-entrant structure shown in Fig. 3(a) and 3(b), even in the lyophilic state in which the liquid droplet forms a contact angle θE of 90° or less (in Fig. 3, θE = 20°), a downwardly convex meniscus is formed by the surface tension (pinning effect), allowing a capillary phenomenon to occur in an upward direction, and thus the liquid droplet does not enter the recessed portion 100a.

In particular, in the double re-entrant structure in Fig. 3(b), the meniscus has a smaller curvature, allowing a stronger capillary phenomenon to occur in an upward direction. Even if a large pressure ΔP (> Δp) is applied, the structure can support it, whereby excellent liquid repellency is maintained for a long time.

In the re-entrant structure in Fig. 3 (a) and 3 (b) adopted in the present invention, in order to maintain liquid repellency for a long period by making sufficient use of the pinning effect, as well as to obtain initial liquid repellency, it is preferable that the pinning pillar 20 has a pitch p of about 100 nm to 500 µm, the recessed portion 100a has a depth d in a range of about 100 nm to 500 µm, and the head portion 20a of the pinning pillar 20 has a flange width f1, a flange thickness e1, a second flange width f2, and a second flange thickness e2 of about 10 nm to 10 µm.

Further, it is preferable that the rate ϕ of area per unit projected area occupied by the head portions 20a of the pinning pillars 20 in the rugged surface 100 is in a range of 0.05 to 0.8.

As described above, the re-entrant structure shown in Fig. 3 (a) or 3 (b) serves to maintain excellent liquid repellency for a long period even if a liquid is kept in constant contact with the rugged surface 100. In the present invention, fluorine atoms are distributed on the rugged surface 100, so that the effect of maintaining liquid repellency is enhanced further. The amount of fluorine atoms to be distributed depends on how to distribute them on the surface. In particular, when, at a top surface of the head portion 20a of the pinning pillar 20 and a bottom surface of the recessed portion 100a, the element ratio between fluorine atoms and carbon (F/C) is 40% or more, particularly in a range of 50% to 300%, it is possible to obtain super liquid repellency stably as described above without impairing surface strength. The element ratio can be calculated by analyzing the surface elemental composition with an X-ray photoelectron spectroscope device.

By distributing fluorine atoms, in a case, for example, where a viscous fluid such as a curry is in constant contact, liquid repellency as high as that in the initial state is maintained for about six months or more in the single re-entrant structure in Fig. 3(a), and for about almost one year in the double re-entrant structure in Fig. 3(b).

In the present invention, the plastic molded body 1 having the re-entrant structure as described above on its surface and the pinning pillar 20 may be formed of any plastics as long as they can be formed into a predetermined shape, such as a thermoplastic resin, a thermosetting resin and a photocurable resin. Depending on the intended use of the molded body 1, a suitable resin may be selected, and a multilayerd structure may also be applicable.

In general, in the field of packaging materials, typical examples of a resin for the surface formation include olefin-based resins such as polyethylene, polypropylene and a copolymer of ethylene or propylene and another olefin, and polyesters such as polyethylene terephthalate (PET), polyethylene isophthalate and polyethylene naphthalate.

Further, the aforementioned resin may contain a bleeding-type fluorine-containing compound or the like so that fluorine atoms are distributed on the surface as will be described later.

Furthermore, depending on the intended use, a metallic foil such as an aluminum foil may be adhesion-fixed on a back face of the plastic molded body 1, and only the pinning pillar 20 may be formed of another resin depending on the production method to be described later.

### <Production of liquid-repellent plastic molded body>

The liquid-repellent plastic molded body having the above-described re-entrant structure surface according to the present invention is produced mainly by a transfer method or a joining method.

### 1. Transfer method

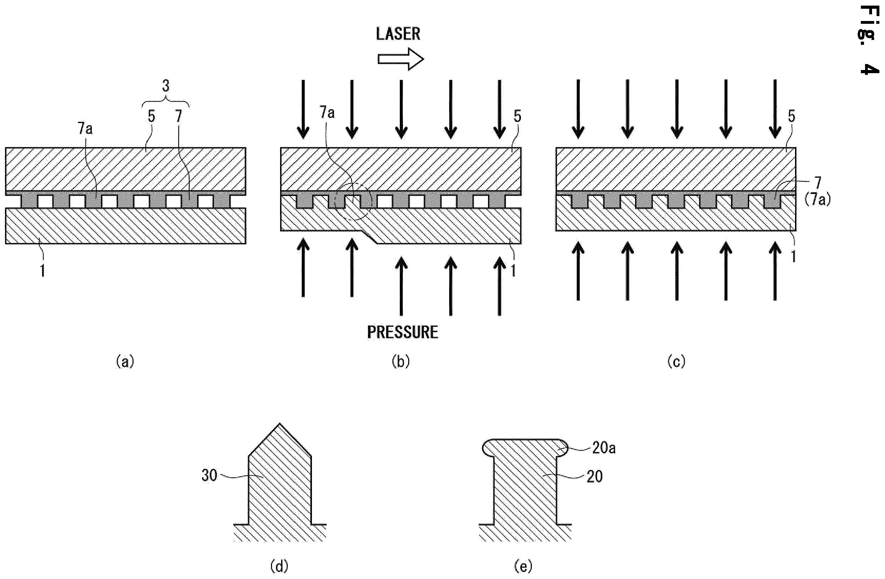

The following transfer method can be referred to as a reflow method (transfer method 1). This method is performed through the processes shown in Fig. 4, and a process of preparing a transfer mold and a transfer process may be performed using the following known art or the like (see, for example, Keisuke Nagato et al.; J. Mat. Proc. Tech., 214, 2444-2449 (2014)).

First, the plastic molded body 1 molded into a predetermined shape and a transfer mold 3 for forming a surface of a precursor of the re-entrant structure are prepared.

The transfer mold 3 includes a laser light-transmissive transparent substrate 5 such as quartz glass and a transfer portion 7 formed on one surface of the substrate 5. The transfer portion 7 is formed by evaporating a material with high laser absorption. For example, the transfer portion 7 is formed of an evaporated film of diamond-like carbon or the like. In the transfer portion 7, holes 7a for transferring straight body-shaped protruded columnar portions are arranged by the known technique of photography and dry etching, thereby forming a transfer surface for forming the precursor of the re-entrant structure.

If the surface itself of the transparent substrate 5 is used as a transfer surface, a laser is transmitted through the transparent plate. Accordingly, the material for the plastic molded body 1 is limited to a material with high laser absorption.

As shown in Fig. 4(a), the surface of the plastic molded body 1 is made to face the transfer surface of the transfer mold 3 as described above.

Next, as shown in Fig. 4(b), the plastic molded body 1 is subjected to a pressure P so as to be pressure-welded to the transfer surface, while a laser light is irradiated from the side of the transparent substrate 5 so as to locally heat the holes 7a formed in the transfer surface, and the holes 7a are pushed into the surface of the plastic molded body 1. The laser light to be used may be any laser as long as it can heat the holes 7a to a level that allows the pushing of the holes 7a.

While the plastic molded body 1 is pressure-welded to the transfer surface as described above, the laser light irradiation position is scanned, so that spot heating and cooling is performed repeatedly. As a result, as shown in Fig. 4(c), the holes 7a are pushed into the predetermined whole surface of the plastic molded body 1.

By the spot heating, only the surface of the molded body 1 is subjected to heating and pushing. Thus, the entire molded body 1 is free from thermal deformation. In particular, even if the molded body 1 is a film-shaped non-rigid product, no wrinkle is produced due to thermal deformation.

Subsequently, the plastic molded body 1 is cooled in the state of Fig. 4 (c), and then detached from the transfer surface, whereby the precursor of the re-entrant structure surface having ruggedness reversed from that on the transfer surface is formed over the predetermined whole surface of the plastic molded body 1.

On the thus-obtained precursor of the re-entrant structure surface, pencil-type pillars 30 each having a tapered tip as shown in Fig. 4(d) are arrayed.

In the reflow method, the top of the pillar 30 on the thus-obtained precursor of the re-entrant structure surface is heated and pressurized or heated under pressure, so that the top portion of the pillar 30 has an enlarged diameter. As a result, as shown in Fig. 4 (e), the pinning pillar 20 having the head portion 20a with an enlarged diameter is formed. An array of the thus-shaped pinning pillars 20 forms, for example, the above-described single re-entrant structure surface shown in Fig. 3(a).

Alternatively, the re-entrant structure surface may also be formed by using another transfer mold having a different form from the transfer mold 3 used in the reflow method.

This method is a normal transfer method (transfer method 2), in which the transfer mold 3 as described above allows the re-entrant structure surface to be formed directly on the surface of the plastic molded body 1 by transfer.

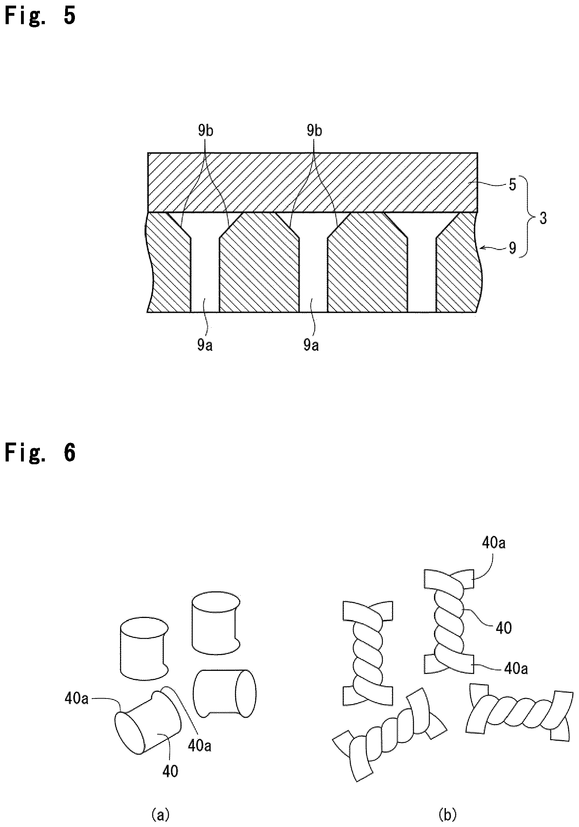

For example, as shown in Fig. 5, the transfer mold 3 to be used here includes the transparent substrate 5 and a transfer substrate 9, which are connected to each other by a screw or the like. In the transfer substrate 9, through holes 9a, each having an enlarged-diameter width portion 9b at its top, are arranged. In view of demolding property, the enlarged-diameter width portion 9b has a tapered surface such that the diameter becomes larger toward the top.

The transfer mold 3 is formed of the transfer substrate 9 and the transparent substrate 5 connected to each other such that the side of the enlarged-diameter width portion 9b of the transfer substrate 9 faces the transparent substrate 5. By arranging the through holes 9a, each having the enlarged-diameter width portion 9b at its top, the re-entrant structure surface can be formed directly on the surface of the plastic molded body 1 by transfer. Namely, as with the method described above, the plastic molded body 1 is put on the transfer mold 3 (transfer substrate 9), subjected to pressure under laser light irradiation, and then detached, resulting in the plastic molded body 1 with the re-entrant structure surface transferred to its surface.

Alternatively, a heat sink substrate 5 may be prepared instead of the transparent substrate 5. A coating material (such as a black coating material) that absorbs a heat beam source such as a halogen lamp and a laser is applied to the surface of the heat sink substrate 5 that does not face the transfer substrate 9, or alternatively this surface is roughened, for example, so that a heat beam is highly absorbed. The transfer mold 3 is irradiated with a halogen lamp or a laser from the side of the heat sink substrate 5 so as to be heated. Thereafter, the plastic molded body 1 is put thereon, subjected to pressure, and then detached, resulting in the plastic molded body 1 with the re-entrant structure surface transferred to its surface.

The transfer substrate 9 having the through holes 9a can be manufactured as follows. That is, each of the through holes 9a is punched by a laser treatment or the like through a plate-like body made of a metal, a thermosetting resin, or the like, and the top of the through hole 9a is chamfered with a cutter or the like.

The above-described transfer method (transfer method 2) has an advantage in that the re-entrant structure surface can be formed directly without involving the precursor of the re-entrant structure surface. However, in view of demolding property, there is a limit on the size of the enlarged-diameter width portion 9b.

In the above-described method, fluorine atoms are distributed on the surface of the re-entrant structure formed as described above.

As a means for distributing fluorine atoms, it is most preferable that a bleeding-type fluorine-containing compound is contained in the aforementioned resin for use in molding the plastic molded body 1. That is, in the plastic molded body 1 molded using a resin that contains a fluorine-containing compound, the fluorine-containing compound bleeds out on the surface with time, so that fluorine atoms are distributed on the surface.

The amount of the fluorine-containing compound to be contained may be set so that the above-mentioned amount of fluorine atoms is distributed on the surface.

Examples of the fluorine-containing compound include a modified olefin-based resin having a fluorine-containing alkyl group, a silane coupling agent having a fluorine-containing alkyl group, a fluorine-containing surfactant, and the like. In particular, if an olefin-based resin is used as a resin for molding the plastic molded body 1, the modified olefin-based resin is preferable.

As an example of the fluorine-containing modified olefin-based resin, a double-chain polymer having a fluoroalkyl group which is represented by the following formula is known (see, for example, Technology for Super Water and Oil Repellency by Tokuzo Kawase, Journal of the Japan Research Association for Textile End-uses, 55(6), 2014). 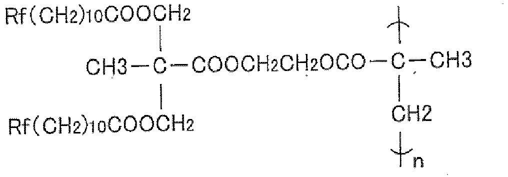 where n is an integer that represents the number of repeating units, and

Rf is a perfluorohexyl group (C₆F₁₃). Other examples of the fluorine-containing compound include polytetrafluoroethylene (PTFE), polychlorotrifluoroethylene (PCTFE), polyvinylidene difluoride (PVDF), polyvinyl fluoride (PVF), perfluoroalkoxy fluororesin (PFA), a tetrafluoroethylene-hexafluoropropylene copolymer (FEP), an ethylen-tetrafluoroethylen copolymer (ETFE), an ethylene-chlorotrifluoroethylene copolymer (ECTFE), and the like. In the present invention, in order to enable injection molding and achieve high liquid repellency, a fluorine-containing acrylic resin, a fluorine-containing silicone resin, and the like are preferable. An example of the fluorine-containing acrylic resin is represented by the following formula:

Rf - CH₂ - CH₂ - OCO - (CX) = CH₂

where Rf is a fluorine-containing alkyl group such as a perfluoroalkyl group, and
X is a hydrogen atom or an alkyl group such as a methyl group.

A polymer obtained by polymerizing this fluorine-containing acrylic resin is preferable.

Further, an example of the fluorine-containing silicone resin is polyorgano siloxane represented by the following formula:

(RO)₂RfSiO - (RORfSiO)n - SiRf(OR)₂

where R is a hydrogen atom or an alkyl group such as a methyl group,
Rf is a fluorine-containing group such as a fluoroalkyl group, and
n is a number representing the degree of polymerization.

In the present invention, from a safety point of view, it is usually considered preferable that the fluorine-containing compound has a fluorine-containing group with a molecular weight less than that of a C8 telomer.

Further, fluorine atoms can also be distributed on the surface by subjecting the re-entrant structure surface to a fluorine plasma treatment.

The fluorine plasma treatment can be performed in a publicly known manner. For example, with the use of CF₄ gas, SiF₄ gas, or the like, the plastic molded body 1 with the re-entrant structure surface, which is placed between a pair of electrodes, is subjected to a high-frequency electric field, so that a plasma of fluorine atoms (atomic fluorine) is generated, and the plasma is allowed to collide with the re-entrant structure surface, whereby the fluorine atoms can be incorporated into molecular chains of a resin forming the re-entrant structure surface. Namely, the surface resin is vaporized or decomposed, while the fluorine atoms are incorporated at the same time.

The above-described transfer method is applied particularly preferably to the production of the liquid-repellent plastic molded body with the re-entrant structure surface shown in Fig. 3(a).

### 2. Joining method

The above-described transfer method is to form the re-entrant structure surface by processing the surface of the plastic molded body 1. On the other hand, the joining method is to externally join the pinning pillars 20 that form the re-entrant structure surface.

In order to perform this method, columnar bodies for forming the pinning pillars, as well as the above-described plastic molded body 1, are prepared.

The columnar body to be used has a form as shown in Fig. 6. In Fig. 6, reference numeral 40 denotes the columnar body.

For example, a columnar body 40 shown in Fig. 6(a) is obtained by cutting plastic staple fiber. By cutting plastic staple fiber, both ends 40a have enlarged diameters, and one of the enlarged-diameter portions corresponds to the head portion 20a of the pinning pillar 20.

Similarly, the columnar body 40 having a form shown in Fig. 6(b) is obtained by cutting a twisted yarn made of plastic fiber. Also in this columnar body 40, the ends 40a have enlarged diameters by the cutting, and the end 40a corresponds to the head portion 20a of the pinning pillar 20. Since the columnar body 40 shown in Fig. 6 (b) is obtained by cutting a twisted yarn, the end 40a is folded. Thus, this columnar body 40 is used preferably particularly for forming the double re-entrant structure in Fig. 3(b).

The plastic fiber for forming the above-described columnar body 40 is of a resin material that is easily fusion-joined to the surface of the plastic molded body 1. While a nylon material is usually used preferably in terms of cost and availability, the same resin material as that used for the surface of the plastic molded body 1 may be spun.

Further, the staple fiber and the twisted yarn to be used for forming the columnar body 40 may have any thickness and length as long as they correspond to the aforementioned pinning pillar 20.

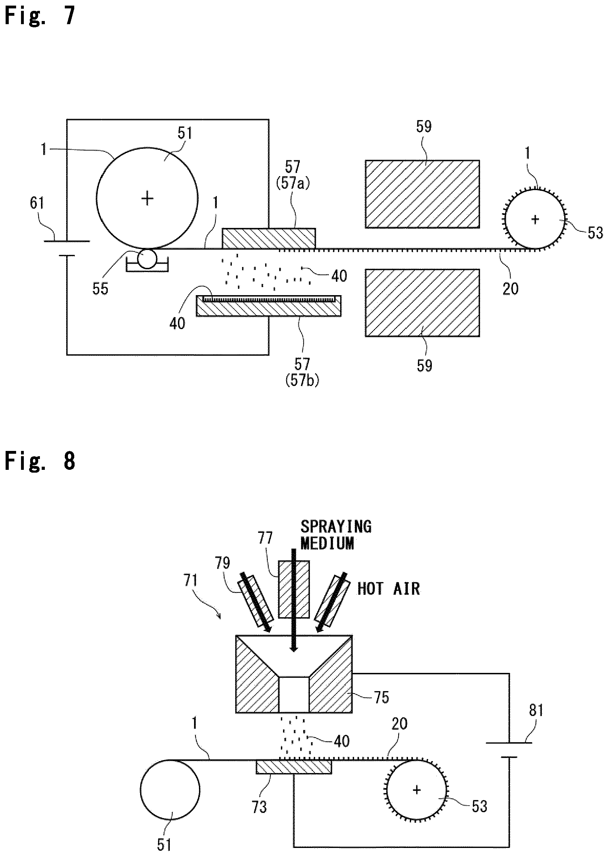

The above-described columnar body 40 can be joined externally to the surface of the plastic molded body 1 by electrostatic flocking or thermal spraying. Figs. 7 and 8 show respective joining methods.

In Figs. 7 and 8, the plastic molded body 1 has a film shape.

### Joining by electrostatic flocking:

In the method shown in Fig. 7, the plastic molded body 1 as a film is wound around a master roller 51. When the film 1 passes through a conveyance path to be wound by a winding roller 53, joining by electrostatic flocking is performed.

More specifically, a coating roller 55, which is placed to face the master roller 51, applies a heat seal lacquer to one surface (on which the re-entrant structure is to be formed) of the film 1.

Further, between the master roller 51 and the winding roller 53, a pair of electrodes 57 (an anode 57a and a cathode 57b) and an oven 59 are placed. The film 1 to which the heat seal lacquer has been applied passes between the pair of electrodes 57, is heated by the oven 59, and then is would by the winding roller 53.

In the configuration as described above, the columnar bodies 40 for forming the aforementioned pinning pillars 20 are held on the cathode 57b, and the film 1 moves along the anode 57a such that the surface on which the heat seal lacquer has been applied faces the cathode side. When the film 1 passes between the electrodes 57 in this manner, a DC voltage (usually, about 40 kV) is applied by a power source 61, so that the columnar bodies 40 on the cathode 57b fly along the electric field, and adhere vertically to the surface of the film 1 on which the heat seal lacquer has been applied. The film 1 on the surface of which the columnar bodies 40 adhere in this manner is heated in the oven 59, so that the columnar bodies 40 are fixed firmly to the surface of the film 1. As a result, the pinning pillars 20 are joined to the surface of the film 1, thereby forming the re-entrant structure. Then, the the film 1 is wound by the winding roller 53 to complete the external joining operation.

### Joining by thermal spraying:

In the method shown in Fig. 8, the plastic molded body 1 as a film is wound around the master roller 51. When the film 1 passes through a conveyance path to be wound by the winding roller 53, the aforementioned columnar bodies 40 are thermally sprayed.

More specifically, thermal spraying equipment 71 and an anode 73 are placed so as to face each other with the conveyance path therebetween. The film 1 moves between the thermal spraying equipment 71 and the anode 73 such that one surface thereof is along the anode 73.

The thermal spraying equipment 71 includes a metallic nozzle 75 having a straight cylindrical space inside, a spraying medium supply pipe 77 for supplying a spraying medium into the straight cylindrical space, and hot air supply pipes 79 for heating the spraying medium.

In the thermal spraying method, the aforementioned columnar bodies 40 are used as the spraying medium. The heated columnar bodies 40 are sprayed on the surface of the film 1 that passes on the cathode 73, so that the columnar bodies 40 are joined to the surface of the film 1. As a result, the re-entrant structure surface on which the pinning pillars 20 are arrayed is formed.

For example, the spraying medium supply pipe 77 of the thermal spraying equipment 71 is supplied with the aforementioned columnar bodies 40. The hot air supply pipes 79 supply hot air for heating the columnar bodies 40 as the spraying medium. The temperature of the hot air is set so that the columnar bodies 40 sprayed on the surface of the film 1 are heated to be fusion-joined on the surface of the film 1 with their forms maintained. The temperature differs depending on the material of the columnar bodies 40. Specifically, in case of the columnar bodies 40 made of polyethylene, the temperature is set so that it is about 400°C to 500°C just above the surface of the film 1.

As shown in Fig. 8, the spraying medium supply pipe 77 extends straight to the center of the nozzle 75 so that the columnar bodies 40 are sprayed on the surface of the film 1 assuming a certain direction. A plurality of the hot air supply pipes 79 are provided inclined so as to surround the spraying medium supply pipe 77, thereby heating the columnar bodies 40 uniformly.

When the columnar bodies 40 heated by hot air are sprayed in the above-described manner, a voltage (usually, about 40 kV) is applied between the anode 73 and the nozzle 75 by a power source 81. This allows the heated columnar bodies 40 to be sprayed along the electric field vertically to the surface of the film 1 on the anode 73.

The heated columnar bodies 40 are sprayed to be joined on the surface of the film 1 in this manner, thereby forming the re-entrant structure surface on which the pinning pillars 20 are fixed and arrayed. Then, the film 1 is wound by the winding roller 53 in this state to complete the joining operation.

In the above-described examples shown in Figs. 7 and 8, the molded body 1 has a film form. However, as is obvious for a person skilled in the art, even if the molded body 1 does not have a film form, it is similarly possible to join the columnar bodies 40 to form the re-entrant structure surface on which the pinning pillars 20 are arrayed, unless the molded body 1 is to be conveyed by the roller.

The molded body 1 on the surface of which the re-entrant structure is formed by electrostatic flocking or thermal spraying in the above-described manner is subjected to the aforementioned fluorine plasma treatment, so that fluorine atoms are distributed on the re-entrant structure surface, thereby providing the liquid-repellent plastic molded body of the present invention. Alternatively, a bleeding-type fluorine-containing compound is contained in the plastic molded body 1 and the columnar bodies 40, so that fluorine atoms are distributed by migration, thereby providing the liquid-repellent plastic molded body of the present invention.

The thus-obtained liquid-repellent plastic molded body of the present invention is excellent in liquid repellency or lubricity to various fluids, and thus it is used in various applications. In particular, the liquid-repellent plastic molded body of the present invention achieves excellent liquid repellency, which is as high as that in the initial state, for a long period even in a case where a liquid is kept in constant contact. Further, the above-described re-entrant structure is not damaged by a heat treatment such as retort sterilization, and thus the present invention is applied preferably to the field of packaging.

For example, one having a film form, which is subjected to post-processing for bag forming or the like, is used most preferably as a pouched container or a tube container in which contents are to be preserved for a long period. In particular, even in a case where viscous paste-like contents having a viscosity (25°C) of 250 mPa·s or more are contained, excellent liquid repellency is achieved, so that the contents can be discharged rapidly and completely with nothing adhering and remaining inside the container.

Typical examples of the paste-like contents include a curry, various kinds of thickened food, a gel-like substance such as pudding and yogurt, jam, shampoo, conditioner, a liquid detergent, toothpaste, and the like.

The present invention is not limited to a pouched container or a tube container, and it is also applicable to a cup-shaped container or a tray-type container.

### Explanations of Letters or Numerals:

- 100:: rough surface
- 160:: primary ruggedness
- 160a:: recessed portion
- 160b:: protruded portion
- 165:: secondary ruggedness
- 170:: liquid droplet

## Claims

1. A liquid-repellent plastic molded body having a liquid-repellent surface,
wherein the liquid-repellent surface has a re-entrant structure surface formed by an array of pillars each having a head portion with an enlarged diameter, and
at least a part of the re-entrant structure surface has a fluorine-containing surface in which fluorine atoms are distributed.

2. The liquid-repellent molded body according to claim 1, wherein the fluorine-containing surface is a fluorine plasma-treated surface.

3. The liquid-repellent molded body according to claim 1 having a film form.

4. A pouched container formed from the liquid-repellent molded body in a film form according to claim 3.

5. A method for producing a liquid-repellent plastic molded body comprising the steps of:
preparing a plastic molded body molded into a predetermined shape and a transfer mold having, as a transfer surface, a rugged surface formed by an array of straight body-shaped protruded columnar portions;
transferring the rugged transfer surface of the transfer mold, which is made to face a surface of the plastic molded body, to the surface of the plastic molded body so as to form a precursor of a re-entrant structure surface;
deforming the precursor into a re-entrant structure surface by heating and/or pressurizing pillars distributed on the precursor formed by transfer so as to enlarge a diameter of a top portion of each of the pillars; and
distributing fluorine atoms to at least a part of the re-entrant structure surface.

6. The method according to claim 5, wherein in the step of distributing fluorine atoms, at least a part of the re-entrant structure surface is formed of a resin that contains a fluorine-containing compound, and when the fluorine-containing compound bleeds out, the fluorine atoms are distributed on the surface.

7. The method according to claim 5, wherein in the step of distributing fluorine atoms, at least a part of the re-entrant structure surface is subjected to a fluorine plasma treatment, so that the fluorine atoms are distributed on the surface.

8. A method for producing a liquid-repellent plastic molded body comprising the steps of:
preparing a plastic molded body molded into a predetermined shape and a transfer mold having a rugged transfer surface for forming a rugged re-entrant structure surface by transfer;
transferring the rugged transfer surface of the transfer mold, which is made to face a surface of the plastic molded body, to the surface of the plastic molded body so as to form a re-entrant structure surface on the surface of the plastic molded body; and
distributing fluorine atoms to at least a part of the re-entrant structure surface.

9. The method according to claim 8, wherein in the step of distributing fluorine atoms, at least a part of the re-entrant structure surface is formed of a resin that contains a fluorine-containing compound, and when the fluorine-containing compound bleeds out, the fluorine atoms are distributed on the surface.

10. The method according to claim 8, wherein in the step of distributing fluorine atoms, at least a part of the re-entrant structure surface is subjected to a fluorine plasma treatment, so that the fluorine atoms are distributed on the surface.

11. A method for producing a liquid-repellent plastic molded body comprising the steps of:
preparing a plastic molded body molded into a predetermined shape and a plastic columnar body having an end surface with an enlarged diameter;
forming a re-entrant structure surface by joining a plurality of the plastic columnar bodies to a surface of the plastic molded body; and
distributing fluorine atoms to at least a part of the re-entrant structure surface.

12. The method according to claim 11, wherein in the step of distributing fluorine atoms, at least a part of the re-entrant structure surface is formed of a resin that contains a fluorine-containing compound, and when the fluorine-containing compound bleeds out, the fluorine atoms are distributed on the surface.

13. The method according to claim 11, wherein in the step of distributing fluorine atoms, at least a part of the re-entrant structure surface is subjected to a fluorine plasma treatment, so that the fluorine atoms are distributed on the surface.

14. The method according to claim 11, wherein in the step of forming a re-entrant structure surface, the plastic columnar bodies are joined to the surface of the plastic molded body by electrostatic flocking.

15. The method according to claim 11, wherein in the step of forming a re-entrant structure surface, the plastic columnar bodies are joined to the surface of the plastic molded body by thermally spraying the plastic columnar bodies on the surface of the plastic molded body.
